# EUROPÄISCHE PATENTSCHRIFT

(11) **EP 2 627 894 B1**
(45) Veröffentlichungstag und Bekanntmachung des Hinweises auf die Patenterteilung: **21.02.2018**
(21) Anmeldenummer: 11754662.2
(22) Anmeldetag: 08.09.2011
(51) Int. Cl.: F02P 23/04, H01S 5/183

(54) **LASERZÜNDEINRICHTUNG FÜR EINE BRENNKRAFTMASCHINE UND BETRIEBSVERFAHREN HIERFÜR**
LASER-IGNITION SYSTEM FOR AN INTERNAL COMBUSTION ENGINE AND OPERATING METHOD THEREFOR
SYSTÈME D'ALLUMAGE LASER POUR MOTEUR À COMBUSTION INTERNE ET PROCÉDÉ PERMETTANT DE FAIRE FONCTIONNER LEDIT SYSTÈME

(30) Priorität: 14.10.2010 DE 102010042453
(43) Veröffentlichungstag der Anmeldung: 21.08.2013
(73) Patentinhaber: Robert Bosch GmbH, 70442 Stuttgart (DE)
(72) Erfinder: HARTKE, Rene, 70178 Stuttgart (DE); RIDDERBUSCH, Heiko, 71701Schwieberdingen (DE)
(86) Internationale Anmeldenummer: PCT/EP2011/065572
(87) Internationale Veröffentlichungsnummer: WO 2012/048965

(56) Entgegenhaltungen:
- WO-A1-95/28756
- WO-A1-2005/066488
- WO-A2-2007/071794
- DE-A1-102007 040 119
- DE-A1-102009 029 096

## Beschreibung

### Stand der Technik

Die Erfindung geht aus von einer Laserzündeinrichtung für eine Brennkraftmaschine, mit einer einen laseraktiven Festkörper und eine, vorzugsweise passive, Güteschaltung aufweisenden Lasereinrichtung und mit einer Pumplichtquelle zum optischen Pumpen der Lasereinrichtung und von einem Verfahren zum Betreiben einer derartigen Laserzündeinrichtung wie sie zum Beispiel aus der WO 2005/066488 bekannt sind.

### Offenbarung der Erfindung

Es ist Aufgabe der vorliegenden Erfindung, eine verbesserte Laserzündeinrichtung und ein verbessertes Betriebsverfahren anzugeben.

Diese Aufgabe wird bei der Laserzündeinrichtung der eingangs genannten Art erfindungsgemäß dadurch gelöst, dass die Pumplichtquelle eine Mehrzahl oberflächenemittierender Halbleiterlaser aufweist. Die erfindungsgemäße Verwendung oberflächenemittierender Halbleiterlaser (Englisch: vertical cavity surface emitting laser, VCSEL) bietet eine Vielzahl von Vorteilen für den Betrieb einer Laserzündeinrichtung. Die im Vergleich zu Festkörperlasern geringere Temperaturempfindlichkeit ermöglicht vorteilhaft die Nutzung von VCSEL-Laserquellen auch in direkter Nähe zu der Brennkraftmaschine, so dass keine Notwendigkeit besteht, die Pumplichtquelle entfernt von der Brennkraftmaschine anzuordnen. Unter Verwendung des VCSEL-Konzepts ist eine einfache Luftkühlung üblicherweise ausreichend, so dass auf eine Wasserkühlung, wie sie seither zur Verwendung von im Bereich der Brennkraftmaschine betriebenen Halbleiterlasern vorgesehen ist, verzichtet werden kann.

Durch die geringe Temperaturempfindlichkeit der von einem VCSEL-Laser erzeugten Wellenlänge von etwa 0,06 nm/K (Nanometer pro Kelvin) ist ferner eine einfache Regelung der Temperatur an dem Halbleiterlaser ermöglicht.

Die Robustheit von VCSEL-Laserquellen ermöglicht darüberhinaus einen einfacheren Aufbau insbesondere von Laserzündkerzen, die üblicherweise wesentliche Komponenten einer laserbasierten Zündeinrichtung für eine Brennkraftmaschine aufnehmen. Speziell kann auf Querschnittswandler in der Laserzündkerze verzichtet werden, der Einsatz von Elementen zur Eliminierung von Rückkopplungseffekten ist ebenfalls nicht erforderlich. Derartige Elemente sind bei herkömmlichen Laserzündsystemen mit Festkörperlasern üblicherweise vorzusehen, um die Rückwirkung der hochenergetischen Laserzündimpulse auf konventionelle Pumplichtquellen zu reduzieren.

Die Linienbreite von VCSEL-Arrays liegt typischerweise unter der Linienbreite von kantenemittierenden Lasern oder anderen Halbleiterlasern. Dadurch kann eine besonders effiziente Absorption der von der Pumplichtquelle erzeugten Pumpstrahlung in dem gepumpten Festkörper-Lasermaterial gewährleistet werden.

Besonders bevorzugt werden VCSEL-Arrays aus sehr vielen einzelnen oberflächenemittierenden Laseremittern aufgebaut, so dass durch eine entsprechende Kombination aus serieller und paralleler elektrischer Verschaltung ein Nennbetriebsstrom und eine Nennbetriebsspannung an unterschiedliche Betriebsbedingungen der Brennkraftmaschine beziehungsweise einer Steuereinrichtung für die Laserzündeinrichtung angepasst werden können. Insbesondere können so auch Maßnahmen zur elektromagnetischen Verträglichkeit im Bereich der Brennkraftmaschine unterstützt werden, die aufgrund der verhältnismäßig hohen Stromstärken, welche mit verhältnismäßig hohen Frequenzen geschaltet werden, auftreten können. Durch eine individuelle elektrische Verschaltung vieler einzelner VCSEL-Emitter kann die Pumplichtquelle sehr einfach an eine elektrische Energieversorgung für die VCSEL-Laserquelle angepasst werden.

Darüberhinaus ist die Ausgangsleistung von VCSEL-Arrays über die Emissionsfläche skalierbar, so dass sich ohne große konstruktive Änderungen an einem Aufbau der Laserzündeinrichtung die Energie der Laserzündimpulse variieren lässt, nämlich durch die Auslegung einer Pumplichtquelle mit entsprechender Ausgangsleistung.

Ein weiterer Vorteil von VCSEL-Arrays bei der Verwendung in einer Laserzündeinrichtung besteht darin, dass durch die geometrisch einfache Pumpanordnung leicht zusätzliche Sensoren in einem die Pumplichtquelle aufweisenden Pumpmodul positioniert werden können.

Bei einer vorteilhaften Ausführungsform ist eine Lichtleiteinrichtung vorgesehen, über die von der Pumplichtquelle erzeugten Pumpstrahlung in die Lasereinrichtung einstrahlbar ist. Die Lichtleiteinrichtung weist bevorzugt im Wesentlichen Kegel-, Prisma-, Quader-, Zylinder- oder Pyramidenform auf, wobei eine Einkoppelfläche, durch die von der Pumplichtquelle erzeugte Pumpstrahlung in die Lichtleiteinrichtung eingekoppelt wird bevorzugt in etwa parallel zu einer Auskoppelfläche angeordnet ist, welche zum Beispiel bei der Ausbildung einer Kegelform die Deckelfläche eines entsprechenden Kegelstumpfs bildet.

Durch die geringe Divergenz von VCSEL-Arrays bei der Pumplichtquelle und der nahezu beliebigen Form der das Pumplicht beziehungsweise die Pumpstrahlung emittierenden Fläche können bevorzugt verhältnismäßig kleinbauende und symmetrische Lichtleiteinrichtungen verwendet werden.

Bei einer weiteren bevorzugten Ausführungsform ist die Lichtleiteinrichtung zumindest teilweise ausgebildet aus Glas und/oder kristallinem und/oder keramischem Material. Dabei sind insbesondere ein hoher Brechungsindex und eine gute Bearbeitbarkeit vorteilhaft. Bevorzugt wird die Geometrie des Lichtleiters an die Divergenz der oberflächenemittierenden Halbleiterlaser der Pumplichtquelle angepasst, so dass für die gesamte erzeugte Pumpstrahlung die Bedingung der Totalreflexion an den Mantelflächen der Lichtleiteinrichtung erfüllt ist. Die Länge der Lichtleiteinrichtung kann beispielsweise durch den gewünschten Grad an Reduzierung der Emissionsfläche angepasst werden.

Bei einer weiteren bevorzugten Ausführungsform ist vorgesehen, dass die Lichtleiteinrichtung die Pumplichtquelle und/oder die Lasereinrichtung direkt oder mittels eines Kontaktmediums, wie beispielsweise einem Index-Matching-Gel, kontaktiert, wodurch eine besonders effiziente Einkopplung der Pumpstrahlung in die Lasereinrichtung beziehungsweise den laseraktiven Festkörper der Lasereinrichtung gegeben ist.

Ein direkter Kontakt kann beispielsweise durch Kleben, Ansprengen hergestellt werden. Diese Ausführungsformen der Erfindung weisen eine besonders hohe Robustheit gegen Dejustage der Komponenten (Pumplichtquelle, Lichtleiter, Lasereinrichtung) und geringe Koppelverluste auf.

Alternativ oder ergänzend kann eine strahlformende Optik zwischen die Lichtleiteinrichtung und die Lasereinrichtung eingebracht werden. Neben der Einkopplung der Pumpstrahlung direkt in die Lasereinrichtung kann unter Verwendung der erfindungsgemäßen Lichtleiteinrichtung die Pumpstrahlung auch in eine Lichtleitfaser eingekoppelt werden.

Bei einer weiteren vorteilhaften Ausführungsform ist vorgesehen, dass die Pumplichtquelle eine Mehrzahl von räumlich voneinander getrennt angeordneten oberflächenemittierenden Halbleiterlasern, insbesondere Gruppen von Halbleiterlasern, aufweist, und dass von den Gruppen von Halbleiterlasern erzeugte Pumpstrahlung direkt oder über eine Fokussieroptik in die Lasereinrichtung einstrahlbar ist. Dadurch lassen sich besonders vorteilhaft voneinander getrennte Pumpvolumina in der Lasereinrichtung beziehungsweise in ihrem laseraktiven Festkörper realisieren, so dass vorteilhaft mehrere Laserimpulse gleichzeitig erzeugt werden können. Dabei arbeiten die individuell mit Pumpstrahlung beaufschlagten Pumpvolumina unabhängig voneinander als Laserresonatoren.

Bei einer weiteren bevorzugten Ausführungsform ist vorgesehen, dass die Pumplichtquelle mehrere Pumplichteinheiten aufweist, wobei eine erste Pumplichteinheit so angeordnet und ausgebildet ist, dass sie die Lasereinrichtung longitudinal pumpen kann, und wobei mindestens eine weitere Pumplichteinheit so ausgebildet und angeordnet ist, dass sie die Lasereinrichtung transversal pumpen kann.

Das transversale Pumpen sorgt vorteilhaft für einen besonders einfachen Energieeintrag von Pumpenergie in das Lasermedium, das heißt den laseraktiven Festkörper, und die longitudinale Pumpstrahlung bewirkt die Ausbildung einer Lasermode in dem laseraktiven Festkörper mit guter Strahlqualität.

Eine besonders effiziente Einkopplung der transversal zuzuführenden Pumpstrahlung in die Lasereinrichtung ergibt sich weiteren Ausführungsform zufolge dann, wenn die für das transversale optische Pumpen vorgesehenen Pumplichteinheiten jeweils eine im Wesentlichen streifenförmige, flächige Anordnung aufweisen, die sich im Wesentlichen parallel zu einer Längsachse einer Lasereinrichtung erstreckt. Zusätzlich kann mindestens einer für das transversale optische Pumpen vorgesehenen Pumplichteinheit eine Zylinderlinse zugeordnet sein zur Bündelung der Pumpstrahlung in die Lasereinrichtung.

Als eine weitere Lösung der Aufgabe der vorliegenden Erfindung ist ein Verfahren gemäß Patentanspruch 10 angegeben. Das erfindungsgemäße Verfahren sieht vor, dass die Pumplichtquelle eine Mehrzahl oberflächenemittierender Halbleiterlaser (VCSEL) aufweist, die die Lasereinrichtung optisch pumpen.

Bei einer bevorzugten Ausführungsform des erfindungsgemäßen Betriebsverfahrens ist vorgesehen, dass unterschiedliche Volumenbereiche der Lasereinrichtung beziehungsweise des laseraktiven Festkörpers getrennt voneinander mit Pumplicht beaufschlagt werden. Besonders bevorzugt können hierdurch mehrere Laserimpulse im Wesentlichen gleichzeitig erzeugt werden.

Bei einer weiteren vorteilhaften Ausführungsform ist vorgesehen, dass die Lasereinrichtung mittels einer ersten Pumplichteinheit longitudinal gepumpt wird, und dass die Lasereinrichtung mittels mindestens einer weiteren Pumplichteinheit transversal gepumpt wird.

Besonders bevorzugt erzeugt die erste Pumplichteinheit Pumpstrahlung mit einem im Wesentlichen kreisförmigen Strahlquerschnitt, die zum longitudinalen Pumpen der Lasereinrichtung verwendet wird, wodurch eine Lasermode besonders guter Strahlqualität entsteht.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung beziehungsweise Darstellung in der Beschreibung beziehungsweise in der Zeichnung.

In der Zeichnung zeigt:
- Figur 1: Eine Brennkraftmaschine mit einem erfindungsgemäßen laserbasierten Zündsystem,
- Figur 2: schematisch eine erste Ausführungsform einer Laserzündkerze aus Figur 1 im Detail,
- Figur 3: ein laserbasiertes Zündsystems mit entfernt angeordneter Pumplichtquelle,
- Figur 4: eine Ausführungsform erfindungsgemäße Ausführungsform einer Laserzündeinrichtung mit in einer Laserzündkerze integrierter Pumplichtquelle,
- Figur 5a bis 5d: weitere Ausführungsformen der Laserzündeinrichtung mit einer Lichtleiteinrichtung zur Einkopplung von Pumpstrahlung in die Lasereinrichtung,
- Figur 6a: eine weitere Ausführungsform einer Pumplichtquelle,
- Figur 6b: schematisch die Beaufschlagung einer Lasereinrichtung mit Pumplicht durch die Pumplichtquelle gemäß Figur 6a,
- Figur 6c: eine weitere Ausführungsform einer erfindungsgemäßen Pumplichtquelle,
- Figur 7a: schematisch eine Seitenansicht einer weiteren Ausführungsform, und
- Figur 7b: schematisch eine Draufsicht auf die Ausführungsform gemäß Figur 7a.

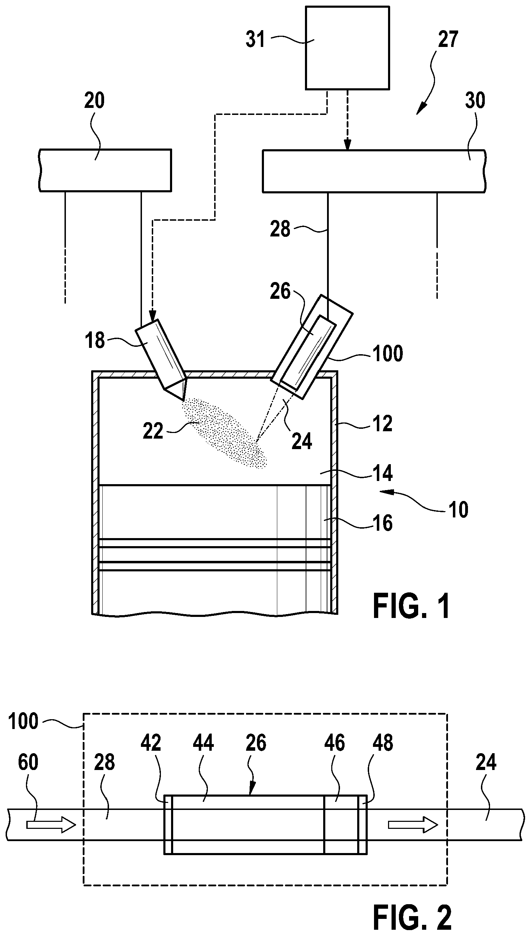

Eine Brennkraftmaschine trägt in Figur 1 insgesamt das Bezugszeichen 10. Sie dient zum Antrieb eines nicht dargestellten Kraftfahrzeugs oder zur Stromerzeugung im stationären Betrieb. Die Brennkraftmaschine 10 umfasst mehrere Zylinder, von denen in Figur 1 nur einer mit dem Bezugszeichen 12 bezeichnet ist. Ein Brennraum 14 des Zylinders 12 wird von einem Kolben 16 begrenzt. Kraftstoff gelangt in den Brennraum 14 direkt durch einen Injektor 18, der an einen auch als Rail bezeichneten Kraftstoff-Druckspeicher 20 angeschlossen ist.

In den Brennraum 14 eingespritzter Kraftstoff 22 wird mittels eines Laserstrahls 24 entzündet, der vorzugsweise in Form eines Laserimpulses 24 von einer eine Lasereinrichtung 26 aufweisenden Laserzündkerze 100 in den Brennraum 14 abgestrahlt wird. Hierzu wird die Lasereinrichtung 26 über eine Lichtleitereinrichtung 28 mit einem Pumplicht gespeist, welches von einer Pumplichtquelle 30 bereitgestellt wird. Die Pumplichtquelle 30 wird von einem Steuergerät 31 gesteuert, das auch den Injektor 18 ansteuert.

Die Pumplichtquelle 30 bildet zusammen mit der Lichtleitereinrichtung 28 und der die Lasereinrichtung 26 aufweisenden Laserzündkerze 100 ein laserbasiertes Zündsystem 27 der Brennkraftmaschine 10.

Wie aus Figur 2 ersichtlich ist, weist die Lasereinrichtung 26 neben einem laseraktiven Festkörper 44 erfindungsgemäß auch eine passive Güteschaltung 46 auf, so dass die Komponenten 44, 46 zusammen mit einem Einkoppelspiegel 42 und einem Auskoppelspiegel 48 einen Laser-Oszillator bilden.

Die grundsätzliche Funktionsweise der Lasereinrichtung 26 ist folgende: Pumplicht 60, das der Lasereinrichtung 26 über die Lichtleitereinrichtung 28 zugeführt wird, tritt durch den für eine Wellenlänge des Pumplichts 60 durchsichtigen Einkoppelspiegel 42 in den laseraktiven Festkörper 44 ein. Dort wird das Pumplicht 60 absorbiert, was zu einer Besetzungsinversion führt. Die zunächst hohen Transmissionsverluste der passiven Güteschaltung 46 verhindern eine Laser-Oszillation in der Lasereinrichtung 26. Mit steigender Pumpdauer steigt jedoch auch die Strahlungsdichte in dem Inneren des durch den laseraktiven Festkörper 44 und die passive Güteschaltung 46 sowie die Spiegel 42, 48 gebildeten Resonators. Ab einer gewissen Strahlungsdichte bleicht die passive Güteschaltung 46 beziehungsweise ein sättigbarer Absorber der passiven Güteschaltung 46 aus, so dass eine Laser-Oszillation in dem Resonator zustande kommt.

Durch diesen Mechanismus wird ein Laserstrahl 24 in Form eines sog. Riesenimpulses erzeugt, der durch den Auskoppelspiegel 48 hindurchtritt und nachfolgend als Laserzündimpuls bezeichnet wird.

Anstelle der vorstehend beschriebenen passiven Güteschaltung 46 ist auch der Einsatz einer aktiven Güteschaltung denkbar.

Erfindungsgemäß weist die Pumplichtquelle 30 eine Mehrzahl von oberflächenemittierenden Halbleiterlasern auf, die englisch auch als vertical cavity surface emitting laser (VCSEL) bezeichnet werden.

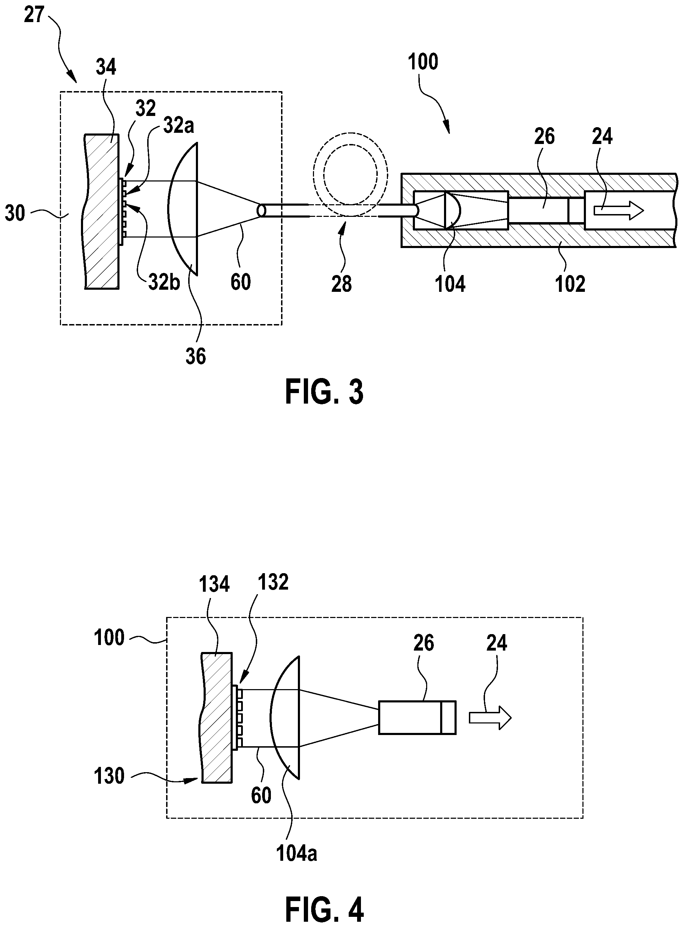

Figur 3 zeigt schematisch eine Seitenansicht auf eine Laserzündeinrichtung 27 wie sie bereits durch Figur 1 schematisch angedeutet worden ist.

Eine Laserzündkerze 100 weist eine in dem Zündkerzengehäuse 102 angeordnete Lasereinrichtung 26 auf, die beispielsweise gemäß Figur 2 ausgebildet ist und zur Erzeugung von Laserimpulsen 24 dient. Der Laserzündkerze 100 ist eine Pumplichtquelle 30 zugeordnet, die über mehrere VCSEL-Laserquellen, mithin mindestens ein sogenanntes VCSEL-Array 32 verfügt, wobei einzelne oberflächenemittierende Halbleiterlaser 32a, 32b, ... des VCSEL-Arrays auf einer gemeinsamen Wärmesenke 34 angeordnet sind.

Dem VCSEL-Array 32 ist eine Fokussieroptik 36 optisch nachgeordnet, die die von dem VCSEL-Array erzeugte Pumpstrahlung 60 auf eine in Figur 3 nicht bezeichnete Einkoppelfläche der Lichtleitereinrichtung 28 bündelt. Über die Lichtleitereinrichtung 28 wird der Laserzündkerze 100 die Pumpstrahlung 60 zugeführt. In der Laserzündkerze 100 wird die von der Lichtleitereinrichtung 28 zugeführte Pumpstrahlung 60 erneut geformt, vorliegend durch die Fokussieroptik 104, die die mit einem gewissen Divergenzwinkel aus der Lichtleitereinrichtung 28 austretende Pumpstrahlung 60 auf die Lasereinrichtung 26 beziehungsweise den laseraktiven Festkörper 44 der Lasereinrichtung 26 bündelt.

Bei dem VCSEL-Array 32 handelt es sich bevorzugt um ein sogenanntes High-Power-VCSEL-Array, das in an sich bekannter Weise auf der Wärmesenke 34 montiert und so elektrisch kontaktiert ist, dass es über Ansteuerleitungen (nicht gezeigt) mit Energie versorgbar ist, um die Erzeugung von Pumpstrahlung 60 zu steuern.

Zur Einkopplung der Pumpstrahlung 60 in die Lichtleitereinrichtung 28 kann eine als einfache, gepresste Optik ausgebildete Fokussierlinse 36 verwendet werden.

Den einzelnen Laseremittern des VCSEL-Arrays 32 können einer weiteren vorteilhaften Ausführungsform zufolge auch Mikrolinsen (nicht gezeigt) zugeordnet sein, die die Divergenz der Pumpstrahlung 60 stark reduzieren.

Figur 4 zeigt schematisch eine erfindungsgemäße Anordnung einer Laserzündeinrichtung, bei der die Pumplichtquelle 130 - im Unterschied zu der Ausführungsform gemäß Figur 3 - direkt in die Laserzündkerze 100 integriert ist Daher ist bei der Ausführung gemäß Figur 4 keine separate Lichtleitereinrichtung 28 erforderlich; die Pumpstrahlung 60 kann vielmehr direkt von dem VCSEL-Array 132 über eine Fokussieroptik 104a in die Lasereinrichtung 26 eingestrahlt werden, die daraufhin in bereits beschriebener Weise einen Laserimpuls 24 erzeugt. Das VCSEL-Array 132 ist auf einer Wärmesenke 134 angeordnet, die bevorzugt stoffschlüssig oder sogar einstückig mit dem Gehäuse 102 (Figur 3) der Laserzündkerze 100 verbunden ist.

Durch den Wegfall der Lichtleitereinrichtung 28 und der entfernt zu der Laserzündkerze 100 angeordneten Pumplichtquelle (vergleiche Ausführungsform gemäß Figur 3) ergibt sich bei der Ausführungsform gemäß Figur 4 eine besonders kostengünstige Konfiguration mit reduzierter Fehleranfälligkeit.

Bei der vorstehend unter Bezugnahme auf die Figuren 3, 4 beschriebenen Konfigurationen kann zusätzlich auch ein transversales optisches Pumpen erfolgen, bei dem entsprechende zusätzliche VCSEL-Arrays (nicht gezeigt) lateral zu der Lasereinrichtung 26 angeordnet sind.

Besonders vorteilhafte Wellenlängen für das VCSEL-Array der Pumplichtquelle 30, 130 sind 806 Nanometer (nm), 885 nm, 914 nm, 946 nm, 975 nm und 980 nm. Durch die geringe Linienbreite des VCSEL-Arrays 32, 132 können auch Absorptionslinien des laseraktiven Festkörpers 44 mit geringer Breite verwendet werden. So ist zum Beispiel das Pumpen von Nd:YAG bei 885 nm leichter zu realisieren als mit herkömmlichen Pumplichtquellen, die beispielsweise über kantenemittierende Halbleiterlaser verfügen.

Weitere bekannte Laserkonzepte, wie zum Beispiel die Verwendung eines Oszillators mit einem nachgeordneten oder in einen Resonator integrierten optischen Verstärker, sind auf das Pumpen mit VCSEL-Arrays 32, 132 übertragbar.

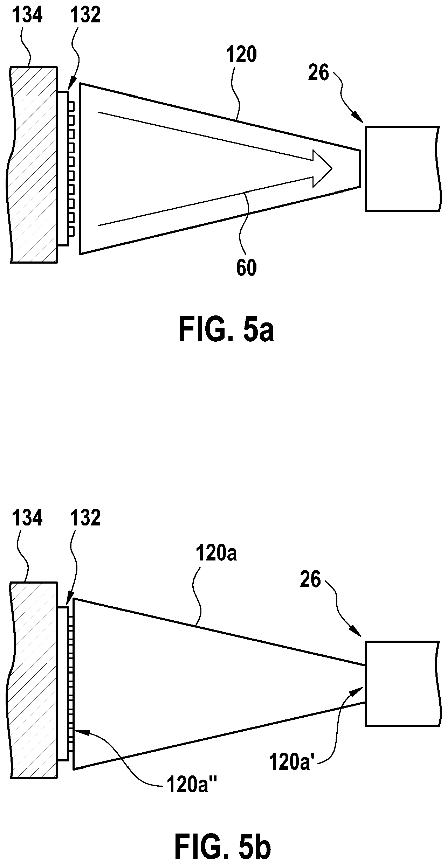

Figur 5a zeigt schematisch eine weitere Ausführungsform einer Laserzündeinrichtung, bei der wiederum ein VCSEL-Array 132 auf einer Wärmesenke 134 angeordnet ist und Pumpstrahlung 60 zur Einstrahlung in eine Lasereinrichtung 26 erzeugt. Vorteilhaft ist bei der Konfiguration gemäß Figur 5a eine Lichtleiteinrichtung 120 vorgesehen, die eine effiziente Einstrahlung beziehungsweise Führung der Pumpstrahlung 60 von dem VCSEL-Array 132 zu der Lasereinrichtung 26 ermöglicht. Wie aus Figur 5a ersichtlich, weist die Lichtleiteinrichtung 120 bevorzugt Kegel- beziehungsweise Kegelstumpfform auf. Andere Formen (Prisma, Quader, Pyramide, Zylinder) sind ebenfalls denkbar.

Besonders bevorzugt ist die Lichtleiteinrichtung 120 möglichst dicht vor dem VCSEL-Array 132 positioniert, um möglichst die gesamte Pumpstrahlung 60 einzusammeln. Über die sich in Figur 5a in horizontaler Richtung erstreckender Länge der Lichtleiteinrichtung 120 wird die Pumpstrahlung 60 kondensiert und kann so in den Festkörperlaser 26 eingekoppelt werden. Anstelle der Einkopplung in einen Festkörperlaser beziehungsweise die Lasereinrichtung 26 kann die Konfiguration 132, 120 auch dazu verwendet werden, Pumpstrahlung 60 effizient in eine Lichtleitereinrichtung 28, wie sie bei der Ausführungsform gemäß Figur 3 zum Einsatz kommt, einzukoppeln.

Das bedeutet, bei der Ausführungsform gemäß Figur 5a könnte die Pumpstrahlung 60 anstelle direkt in die Lasereinrichtung 26 auch in eine Lichtleitereinrichtung 28 (Figur 3) eingekoppelt werden. Dasselbe gilt für die nachstehend unter Bezugnahme auf die Figuren 5b bis 5d beschriebenen weiteren Ausführungsformen mit einer Lichtleiteinrichtung.

Figur 5b zeigt schematisch eine weitere Ausführungsform der Laserzündeinrichtung, bei der eine Lichtleiteinrichtung 120a, die vergleichbar zu der Lichtleiteinrichtung 120 der Ausführungsform gemäß Figur 5a ausgebildet sein kann, zwischen dem VCSEL-Array 132 und der Lasereinrichtung 26 vorgesehen ist. Bei der in Figur 5b abgebildeten Ausführungsform steht eine Einkoppelfläche 120a" der Lichtleiteinrichtung 120a in direktem Kontakt mit einer optischen Oberfläche des VCSEL-Arrays 132, was eine besonders effiziente Einkopplung von Pumpstrahlung in die Lichtleiteinrichtung 120a bewirkt. Analog hierzu ist die Auskoppelfläche 120a' der Lichtleiteinrichtung 120a ebenfalls in direktem Kontakt mit einer Stirnfläche der Lasereinrichtung 26. Die Kontaktierung der betreffenden Flächen 120a', 120a" kann beispielsweise durch Kleben, Ansprengen, Bonden oder durch die Verwendung von Kontaktmedien, wie beispielsweise einem Index-Matching-Gel erzielt werden. Ein besonderer Vorteil dieser Konfiguration ist eine hohe Robustheit gegen Dejustage und besonders geringe Koppelverluste.

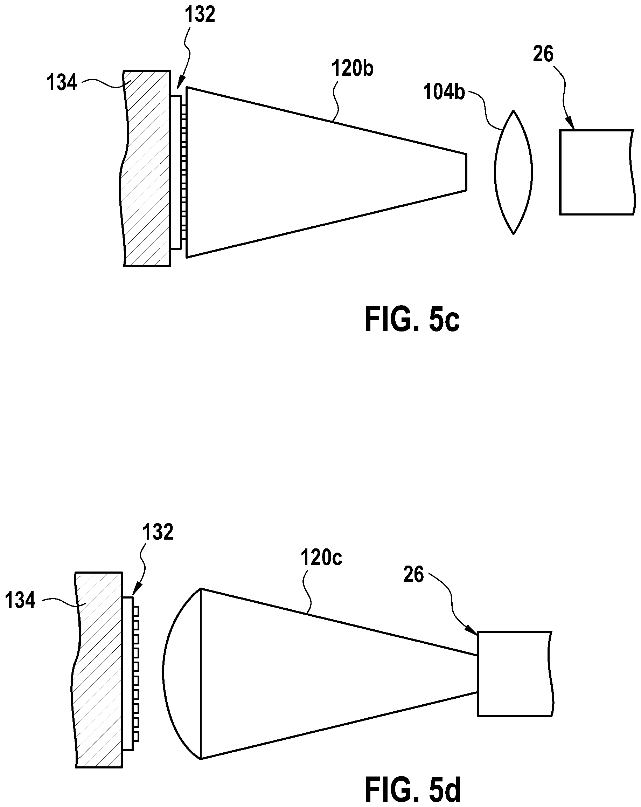

Figur 5c zeigt eine weitere Ausführungsform der Laserzündeinrichtung, bei der eine Lichtleiteinrichtung 120b zur Führung der Pumpstrahlung 60 vorgesehen ist. Zusätzlich zu der Lichtleiteinrichtung 120b ist eine Fokussieroptik 104b vorgesehen, die zwischen der Lichtleiteinrichtung 120b und der Lasereinrichtung 26 angeordnet ist, und die aus der Lichtleiteinrichtung 120b austretende Pumpstrahlung (nicht gezeigt) auf die Lasereinrichtung 26 bündelt, um diese longitudinal zu pumpen. Durch die Fokussieroptik 104b kann die Pumpstrahlung 60 optimal geformt werden.

Figur 5d zeigt eine weitere Ausführungsform einer Laserzündeinrichtung, bei der die Einkoppelfläche der Lichtleiteinrichtung 120c nicht planar ausgebildet, sondern vielmehr gekrümmt ist, um eine Einkoppeleffizienz von Pumpstrahlung aus dem VCSEL-Array 132 in die Lichtleiteinrichtung 120c zu erhöhen. Gleichzeitig kann aufgrund der gekrümmten Einkoppelfläche die Länge der Lichtleiteinrichtung 120c deutlich reduziert werden. Die Krümmung der Einkoppelfläche kann beispielsweise durch Polieren erreicht werden oder auch durch Anbringen eines Linsenelements, das beispielsweise auf eine zunächst planare Einkoppelfläche des Lichtleitelements 120c aufgebondet werden kann.

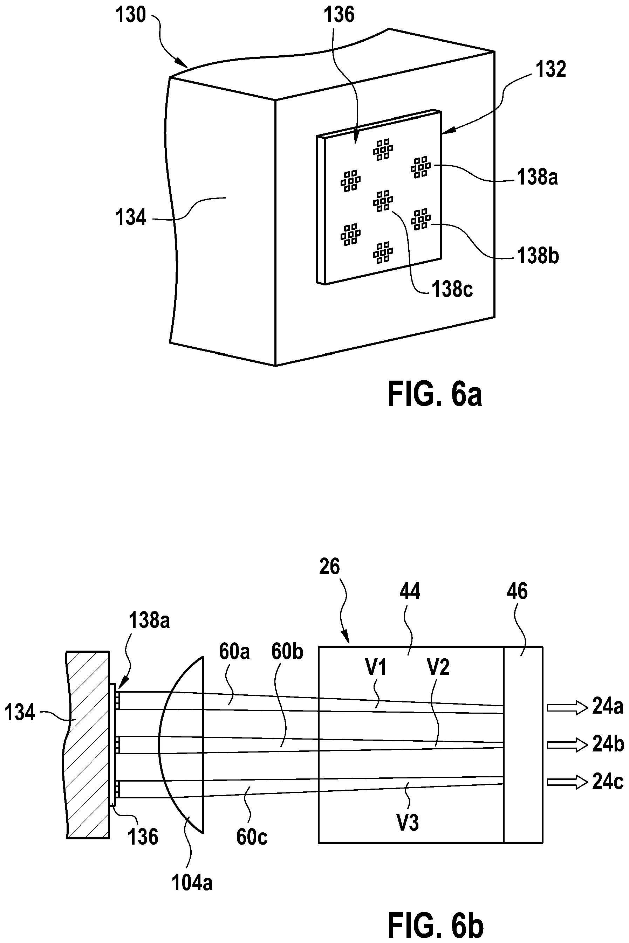

Figur 6a zeigt schematisch eine weitere Ausführungsform einer Pumplichtquelle 130, wie sie bevorzugt in die Laserzündkerze 100 (Figur 2) integriert werden kann. Die Pumplichtquelle 130 weist mehrere Gruppen 138a, 138b, 138c von VCSEL-Arrays auf, die auf einer gemeinsamen Trägeranordnung 136 angeordnet sind. Die Trägeranordnung 136 ist wiederum auf der Wärmesenke 134 angeordnet. Die Gruppierung der unterschiedlichen VCSEL-Arrays 138a, 138b, 138c, .. erfolgt bevorzugt derart, dass sie so weit räumlich voneinander getrennt sind, dass sich ihre unterschiedlichen Pumpstrahlen nicht überlappen. Dadurch können unterschiedliche Volumenbereiche V1, V2, V3 der Lasereinrichtung 26 beziehungsweise des laseraktiven Festkörpers 44 getrennt voneinander optisch gepumpt werden, vergleiche hierzu die Seitenansicht gemäß Figur 6b.

Optional kann eine Fokussieroptik 104a vorgesehen sein, die die Pumplicht-Teilstrahlen 60a, 60b, 60c in geeigneter Weise auf die gewünschten Volumenelemente V1, V2, V3 bündelt.

Jede Gruppe 138a, 138b, 138c von VCSEL-Arrays weist vorteilhaft eine Vielzahl von einzelnen Oberflächenemittern auf, die annähernd in Kreisform angeordnet sind, um eine möglichst runde beziehungsweise kreisförmige Pumpmode zu ermöglichen. Die einzelnen Gruppen 138a, 138b, 138c sollten über eine hinreichend große Ausgangsleistung verfügen, um einen Laserimpuls 24a, 24b, 24c (Figur 6b) in dem Festkörperlaser 44 erzeugen zu können.

Für eine optimierte Abbildung des VCSEL-Arrays 132 ist es vorteilhaft, wenn die emittierte Strahlung 60a, 60b, 60c durch Mikrolinsen (nicht gezeigt) kollimiert wird, die bevorzugt wiederum direkt auf den einzelnen VCSEL-Emittern angeordnet sind.

Aus Figur 6b ist ersichtlich, wie die einzelnen Laserimpulse 24a, 24b, 24c räumlich getrennt voneinander entstehen, was sich durch die räumlich voneinander getrennten, individuell gepumpten Volumenbereiche V1, V2, V3 ergibt. Damit alle Laserimpulse 24a, 24b, 24c möglichst gleichzeitig emittiert werden, kann die elektrische Ansteuerung der Pumplichtquelle 130 beispielsweise so erfolgen, dass einige Mikrosekunden vor dem tatsächlichen Auslösen der Laserimpulse (Ausbleichen des sättigbaren Absorbers der passiven Güteschaltung 46) der Ansteuerstrom des VCSEL-Arrays deutlich erhöht wird. Dadurch wird das Auslösen aller Laserimpulse 24a, 24b, 24c beschleunigt, und die Laserimpulse rücken zeitlich auch näher zusammen.

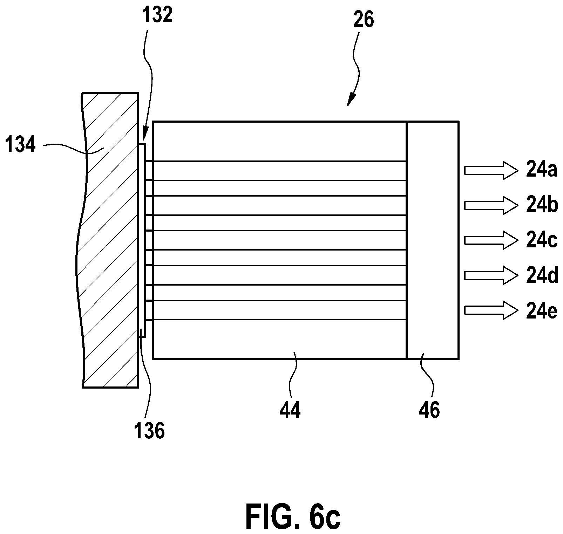

Figur 6c zeigt eine Seitenansicht einer weiteren Ausführungsform einer mehrere VCSEL-Arrays 132 aufweisenden Pumplichtquelle. Bei dieser Ausführungsform werden die einzelnen VCSEL-Arrays so groß gestaltet, dass sie in ihrer Flächenausdehnung dem Durchmesser der zu pumpenden Mode im Festkörperlaser 44 entsprechen. Bei kollimierter Emission der VCSEL-Arrays 132 lässt sich ein guter Überlapp von Pumpmode und Festkörpermode realisieren. Der Festkörperlaser 44 kann vorteilhaft mit dem VCSEL-Array kontaktiert werden, wie es auch aus Figur 6c ersichtlich ist. Da vorliegend insgesamt fünf diskrete VCSEL-Arrays 132 in der Pumplichtquelle vorgesehen sind, werden durch die Lasereinrichtung 26 bei entsprechender Pumplichtbeaufschlagung fünf diskrete Laserimpulse 24a, 24b, 24c, 24d, 24e erzeugt, so dass eine räumliche Mehrfachzündung realisierbar ist.

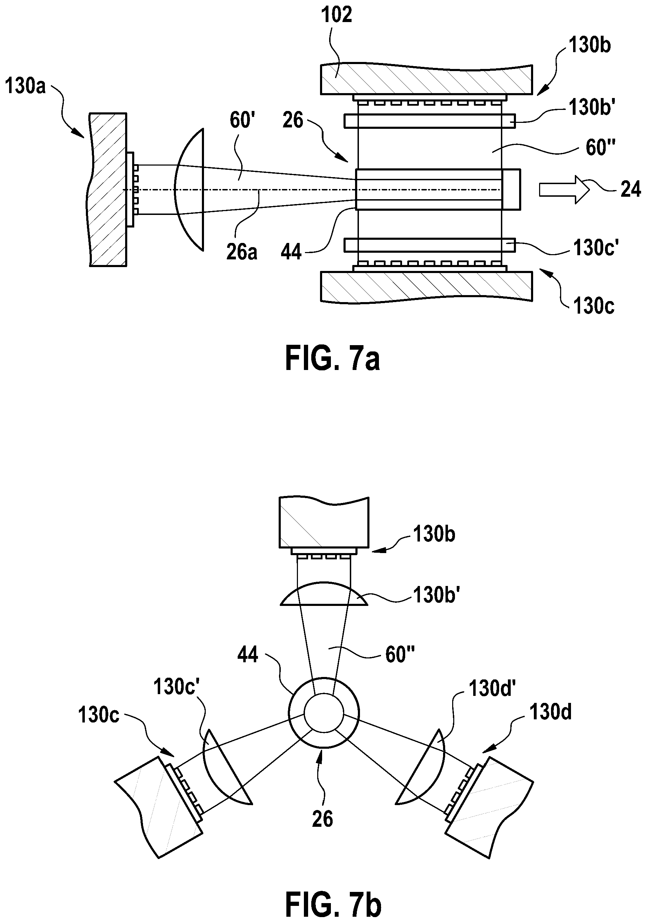

Figur 7a zeigt eine weitere Ausführungsform einer Laserzündeinrichtung, bei der eine erste Pumplichteinheit 130a zum longitudinalen Pumpen der Lasereinrichtung 26 beziehungsweise des laseraktiven Festkörpers 44 vorgesehen ist. Die erste Pumplichteinheit 130a verfügt hierzu wie bereits vorstehend beschrieben über ein oder mehrere Arrays von VCSEL-Lasern. Der ersten Pumplichteinheit 130a optisch nachgeordnet ist eine Fokussieroptik, die die Pumpstrahlung 60' auf die Lasereinrichtung 26 beziehungsweise ihren laseraktiven Festkörper 44 bündelt, wodurch der laseraktive Festkörper 26 longitudinal gepumpt wird. Zusätzlich zu der ersten Pumplichteinheit 130a sind weitere Pumplichteinheiten 130b, 130c, 130d (vergleiche Figur 7b) vorgesehen, die die Lasereinrichtung 26 zusätzlich zu dem longitudinalen optischen Pumpen mittels der Pumpstrahlung 60' auch transversal pumpen, nämlich mit der von ihnen erzeugten Pumpstrahlung 60". Den weiteren, für das transversale optische Pumpen vorgesehenen Pumplichteinheiten 130b, 130c, 130d sind jeweils Zylinderlinsen 130b', 130c', 130d' (Figur 7b) zugeordnet.

Die Pumplichteinheiten 130b, 130c, 130d weisen bevorzugt streifenförmig beziehungsweise rechteckförmig ausgebildete VCSEL-Arrays auf, die sich mit ihrer Längsachse in etwa parallel zu der Längsachse 26a (Figur 7a) der Lasereinrichtung 26 erstrecken und beispielsweise direkt an einer Innenseite eines Gehäuses 102 der Laserzündkerze 100 (Figur 1) angeordnet sein können.

Bei der in Figur 7a, 7b abgebildeten Pumpkonfiguration sind für das transversale Pumpen verhältnismäßig geringe Strahldichten notwendig, da die Pumpleistung über die gesamte Länge des absorbierenden Materials 44 eingebracht werden kann und nur schwach fokussiert werden muss. VCSEL-Arrays für geringe Leistungsdichten sind besonders einfach herzustellen, da sie keine Mikrooptiken benötigen. Die Form der anschwingenden Mode in der Lasereinrichtung 26 wird über das longitudinale Pumpen mittels der ersten Pumplichteinheit 130a positiv beeinflusst beziehungsweise bestimmt. Daher wird für die erste Pumplichteinheit 130a bevorzugt ein kreisrundes VCSEL-Array verwendet oder eine kreisrund ausgebildete Anordnung mehrerer VCSEL-Arrays, die direkt in den Festkörperlaser 44 abgebildet werden. Auf diese Weise kann die Form der anschwingenden Mode in dem Festkörperlaser 44 deutlich besser konfiguriert werden, als für eine rein transversale Pumpanordnung.

Das longitudinale Pumpen kann anstelle der örtlich vorgesehenen ersten Pumplichteinheit 130a auch über eine Lichtleitfaser oder eine strahlformende Optik erfolgen.

Obwohl vorstehend unter Bezugnahme auf die Figuren 7a, 7b insgesamt drei weitere Pumplichteinheiten 130b, 130c, 130d für das transversale optische Pumpen beschrieben sind, kann eine beliebige Anzahl von transversal pumpenden Pumplichteinheiten vorgesehen werden. Besonders bevorzugt sind zwei bis sechs transversal pumpende VCSEL-Arrays.

Die während des Pumpvorgangs nicht durch die Lasereinrichtung 26 absorbierte Leistung kann zusätzlich über einen Spiegel (nicht gezeigt) in den Festkörperlaser 44 zurückgestrahlt werden.

Alternativ zu der Verwendung von VCSEI-Arrays für die transversalen Pumpeinheiten 130b, 130c, 130d können auch andere Halbleiterlaser hierzu verwendet werden, beispielsweise kantenemittierende Halbleiterlaser. Auch in einer solchen Konfiguration kann die Mode des Lasers 44 durch zusätzliches longitudinales Pumpen mit einem VCSEL-Array positiv beeinflusst werden.

Die vorstehend beschriebenen Ausführungsformen des laserbasierten Zündsytems 27 können auch untereinander kombiniert werden.

## Patentansprüche

1. Laserzündeinrichtung (27) für eine Brennkraftmaschine (10), mit einer einen laseraktiven Festkörper (44) und eine Güteschaltung (46) aufweisenden Lasereinrichtung (26) und mit einer Pumplichtquelle (30; 130) zum optischen Pumpen der Lasereinrichtung (26), **dadurch gekennzeichnet, dass** die Pumplichtquelle (30; 130) direkt in eine Laserzündkerze (100) der Laserzündeinrichtung (27) integriert ist und eine Mehrzahl (32; 132) oberflächenemittierender Halbleiterlaser (32a, 32b, ..) aufweist.

2. Laserzündeinrichtung (27) nach Anspruch 1, **dadurch gekennzeichnet, dass** eine Lichtleiteinrichtung (120, 120a, 120b, ..) vorgesehen ist, über die von der Pumplichtquelle (130) erzeugte Pumpstrahlung (60) in die Lasereinrichtung (26) einstrahlbar ist.

3. Laserzündeinrichtung (27) nach Anspruch 2, **dadurch gekennzeichnet, dass** die Lichtleiteinrichtung (120, 120a, 120b, ..) im wesentlichen eine der folgenden Formen aufweist: Kegel, Prisma, Quader, Pyramide, Zylinder.

4. Laserzündeinrichtung (27) nach einem der Ansprüche 2 bis 3, **dadurch gekennzeichnet, dass** die Lichtleiteinrichtung (120, 120a, 120b, ..) zumindest teilweise ausgebildet ist aus Glas und/oder kristallinem und/oder keramischem Material.

5. Laserzündeinrichtung (27) nach einem der Ansprüche 2 bis 4, **dadurch gekennzeichnet, dass** die Lichtleiteinrichtung (120, 120a, 120b, ..) die Pumplichtquelle (130) und/oder die Lasereinrichtung (26) direkt oder mittels eines Kontaktmediums kontaktiert.

6. Laserzündeinrichtung (27) nach einem der vorstehenden Ansprüche, **dadurch gekennzeichnet, dass** die Pumplichtquelle (130) eine Mehrzahl von räumlich voneinander getrennt angeordneten oberflächenemittierenden Halbleiterlasern aufweist, und dass von den Gruppen (138a, 138b, 138c) von Halbleiterlasern erzeugte Pumpstrahlung (60a, 60b, 60c) direkt oder über eine Fokussieroptik (104a) in die Lasereinrichtung (26) einstrahlbar ist.

7. Laserzündeinrichtung (27) nach einem der vorstehenden Ansprüche, **dadurch gekennzeichnet, dass** die Pumplichtquelle (130) mehrere Pumplichteinheiten (130a, 130b, 130c, 130d) aufweist, wobei eine erste Pumplichteinheit (130a) so angeordnet und ausgebildet ist, dass sie die Lasereinrichtung (26) longitudinal pumpen kann, und wobei mindestens eine weitere Pumplichteinheit (130b) so ausgebildet und angeordnet ist, dass sie die Lasereinrichtung (26) transversal pumpen kann.

8. Laserzündeinrichtung (27) nach Anspruch 7, **dadurch gekennzeichnet, dass** die für das transversale optische Pumpen vorgesehenen Pumplichteinheiten (130b, 130c, 130d) jeweils eine im wesentlichen streifenförmige, flächige Anordnung aufweisen, die sich im wesentlichen parallel zu einer Längsachse (26a) der Lasereinrichtung (26) erstreckt.

9. Laserzündeinrichtung (27) nach Anspruch 7, **dadurch gekennzeichnet, dass** mindestens einer für das transversale optische Pumpen vorgesehenen Pumplichteinheit (130b, 130c, 130d) eine Zylinderlinse (130b', 130c', 130d') zugeordnet ist zur Bündelung der Pumpstrahlung in die Lasereinrichtung (26).

10. Verfahren zum Betreiben einer Laserzündeinrichtung (27) für eine Brennkraftmaschine (10), mit einer einen laseraktiven Festkörper (44) und eine Güteschaltung (46) aufweisenden Lasereinrichtung (26) und mit einer Pumplichtquelle (30; 130) zum optischen Pumpen der Lasereinrichtung (26), **dadurch gekennzeichnet, dass** die Pumplichtquelle (30; 130) direkt in eine Laserzündkerze (100) der Laserzündeinrichtung (27) integriert ist und eine Mehrzahl (32; 132) oberflächenemittierender Halbleiterlaser (32a, 32b, ..) aufweist, die die Lasereinrichtung (26) optisch pumpen.

11. Verfahren nach Anspruch 10, **dadurch gekennzeichnet, dass** unterschiedliche Volumenbereiche (V1, V2, V3) der Lasereinrichtung (26) bzw. des laseraktiven Festkörpers (44) getrennt voneinander mit Pumplicht (60a, 60b, 60c) beaufschlagt werden.

12. Verfahren nach Anspruch 11, **dadurch gekennzeichnet, dass** mehrere Laserimpulse (24a, 24b, 24c) im wesentlichen gleichzeitig erzeugt werden.

13. Verfahren nach einem der Ansprüche 10 bis 12, **dadurch gekennzeichnet, dass** die Lasereinrichtung (26) mittels einer ersten Pumplichteinheit (130a) longitudinal gepumpt wird, und dass die Lasereinrichtung (26) mittels mindestens einer weiteren Pumplichteinheit (130b) transversal gepumpt wird.

14. Verfahren nach Anspruch 13, **dadurch gekennzeichnet, dass** die erste Pumplichteinheit (130a) Pumpstrahlung (60') mit einem im wesentlichen kreisförmigen Strahlquerschnitt erzeugt.

## Claims

1. Laser ignition device (27) for an internal combustion engine (10), comprising a laser device (26) having a laser-active solid (44) and a Q-switch (46), and comprising a pump light source (30; 130) for optically pumping the laser device (26), **characterized in that** the pump light source (30; 130) is integrated directly into a laser spark plug (100) of the laser ignition device (27) and comprises a plurality (32; 132) of surface-emitting semiconductor lasers (32a, 32b, ..).

2. Laser ignition device (27) according to Claim 1, **characterized in that** a light guiding device (120, 120a, 120b, ..) is provided, via which pump radiation (60) generated by the pump light source (130) is able to be radiated into the laser device (26).

3. Laser ignition device (27) according to Claim 2, **characterized in that** the light guiding device (120, 120a, 120b, ..) substantially has one of the following shapes: cone, prism, parallelepiped, pyramid, cylinder.

4. Laser ignition device (27) according to either of Claims 2 and 3, **characterized in that** the light guiding device (120, 120a, 120b, ..) is at least partly formed from glass and/or crystalline and/or ceramic material.

5. Laser ignition device (27) according to any of Claims 2 to 4, **characterized in that** the light guiding device (120, 120a, 120b, ..) contacts the pump light source (130) and/or the laser device (26) directly or by means of a contact medium.

6. Laser ignition device (27) according to any of the preceding claims, **characterized in that** the pump light source (130) comprises a plurality of surface-emitting semiconductor lasers arranged in a manner spatially separated from one another, and **in that** pump radiation (60a, 60b, 60c) generated by the groups (138a, 138b, 138c) of semiconductor lasers is able to be radiated into the laser device (26) directly or via a focusing optical unit (104a).

7. Laser ignition device (27) according to any of the preceding claims, **characterized in that** the pump light source (130) comprises a plurality of pump light units (130a, 130b, 130c, 130d), wherein a first pump light unit (130a) is arranged and configured such that it can pump the laser device (26) longitudinally, and wherein at least one further pump light unit (130b) is configured and arranged such that it can pump the laser device (26) transversely.

8. Laser ignition device (27) according to Claim 7, **characterized in that** the pump light units (130b, 130c, 130d) provided for the transverse optical pumping have in each case a substantially strip-shaped, planar arrangement extending substantially parallel to a longitudinal axis (26a) of the laser device (26).

9. Laser ignition device (27) according to Claim 7, **characterized in that** at least one pump light unit (130b, 130c, 130d) provided for the transverse optical pumping is assigned a cylindrical lens (130b', 130c', 130d') for focusing the pump radiation into the laser device (26).

10. Method for operating a laser ignition device (27) for an internal combustion engine (10), comprising a laser device (26) having a laser-active solid (44) and a Q-switch (46), and comprising a pump light source (30; 130) for optically pumping the laser device (26), **characterized in that** the pump light source (30; 130) is integrated directly into a laser spark plug (100) of the laser ignition device (27) and comprises a plurality (32; 132) of surface-emitting semiconductor lasers (32a, 32b, ..), which optically pump the laser device (26).

11. Method according to Claim 10, **characterized in that** different volume regions (V1, V2, V3) of the laser device (26) or of the laser-active solid (44) are impinged on by pump light (60a, 60b, 60c) separately from one another.

12. Method according to Claim 11, **characterized in that** a plurality of laser pulses (24a, 24b, 24c) are generated substantially simultaneously.

13. Method according to any of Claims 10 to 12, **characterized in that** the laser device (26) is pumped longitudinally by means of a first pump light unit (130a), and **in that** the laser device (26) is pumped transversely by means of at least one further pump light unit (130b).

14. Method according to Claim 13, **characterized in that** the first pump light unit (130a) generates pump radiation (60') having a substantially circular beam cross section.

## Revendications

1. Système d'allumage laser (27) pour un moteur à combustion interne (10), doté d'un système laser (26) comportant un corps solide actif laser (44) et un déclenchement (46) et d'une source lumineuse de pompage (30 ; 130) pour pomper optiquement le système laser (26), **caractérisé en ce que** la source lumineuse de pompage (30; 130) est directement intégrée dans une bougie d'allumage laser (100) du système d'allumage laser (27) et comprend une pluralité (32 ; 132) de lasers à semi-conducteurs à émission de surface (32a, 32b, ..).

2. Système d'allumage laser (27) selon la revendication 1, **caractérisé en ce qu'**il est prévu un système de guidage de la lumière (120, 120a, 120b,...) au moyen duquel le rayonnement de pompage (60) généré par la source lumineuse de pompage (130) peut être injecté dans le système laser (26).

3. Système d'allumage laser (27) selon la revendication 2, **caractérisé en ce que** le système de guidage de la lumière (120, 120a, 120b,...) présente sensiblement l'une des formes suivantes : cône, prisme, parallélépipède, pyramide, cylindre.

4. Système d'allumage laser (27) selon l'une quelconque des revendications 2 à 3, **caractérisé en ce que** le système de guidage de la lumière (120, 120a, 120b,...) est constitué au moins partiellement de verre et/ou de matériau cristallin et/ou céramique.

5. Système d'allumage laser (27) selon l'une quelconque des revendications 2 à 4, **caractérisé en ce que** le système de guidage de la lumière (120, 120a, 120b,...) entre en contact avec la source lumineuse de pompage (130) et/ou le système laser (26) directement ou au moyen d'un fluide de contact.

6. Système d'allumage à laser (27) selon l'une quelconque des revendications précédentes, **caractérisé en ce que** la source de lumière de pompage (130) comprend une pluralité de lasers à semi-conducteurs à émission de surface disposés de manière séparée les uns des autres dans l'espace, et **en ce qu'**un rayonnement de pompage (60a, 60b, 60c) généré par les groupes (138a, 138b, 138c) de lasers à semi-conducteurs peut être injecté dans le système laser (26) directement ou par l'intermédiaire d'une optique de focalisation (104a).

7. Système d'allumage laser (27) selon l'une quelconque des revendications précédentes, **caractérisé en ce que** la source lumineuse de pompage (130) comprend une pluralité d'unités de pompage optique (130a, 130b, 130c, 130d), dans lequel une première unité de pompage optique (130a) est agencée et configurée pour pouvoir pomper longitudinalement le système laser (26) et dans lequel au moins une autre unité de pompage optique (130b) est configurée et agencée pour pouvoir pomper transversalement le système laser (26).

8. Système d'allumage laser (27) selon la revendication 7, **caractérisé en ce que** les unités de pompage optique (130b, 130c, 130d) prévues pour le pompage optique transversal présentent respectivement un agencement plat sensiblement en forme de bande, qui s'étend sensiblement parallèlement à un axe longitudinal (26a) du système laser (26).

9. Système d'allumage laser (27) selon la revendication 7, **caractérisé en ce qu'**une lentille cylindrique (130b', 130c', 130d') est associée à au moins une unité de pompage optique (130b, 130c, 130d) prévue pour le pompage optique transversal afin de regrouper le rayonnement de pompage dans le système laser (26).

10. Procédé de mise en fonctionnement d'un système d'allumage laser (27) pour un moteur à combustion interne (10), comprenant un système laser (26) comportant un corps solide actif laser (44) et un déclenchement (46), et une source lumineuse de pompage (30 ; 130) pour pomper optiquement le système laser (26), **caractérisé en ce que** la source lumineuse de pompage (30 ;130) est directement intégrée dans une bougie d'allumage laser (100) du système d'allumage laser (27) et comporte une pluralité (32 ;132) de lasers à semi-conducteur à émission de surface (32a, 32b,...) qui pompent optiquement le système laser (26).

11. Procédé selon la revendication 10, **caractérisé en ce que** différents domaines de volume (V1, V2, V3) du système laser (26) ou du corps solide actif laser (44) sont exposés séparément les uns des autres à la lumière de pompage (60a, 60b, 60c).

12. Procédé selon la revendication 11, **caractérisé en ce que** plusieurs impulsions laser (24a, 24b, 24c) sont générées sensiblement simultanément.

13. Procédé selon l'une quelconque des revendications 10 à 12, **caractérisé en ce que** le système laser (26) est pompé longitudinalement au moyen d'une première unité de pompage optique (130a), et **en ce que** le système laser (26) est pompé transversalement au moyen d'au moins une autre unité de pompage optique (130b).

14. Procédé selon la revendication 13, **caractérisé en ce que** la première unité de pompage optique (130a) génère un rayonnement de pompage (60') présentant une section transversale de faisceau sensiblement circulaire.
